# EUROPEAN PATENT APPLICATION

(11) **EP 3 142 469 A1**
(43) Date of publication of application: **15.03.2017**
(21) Application number: 15788619.3
(22) Date of filing: 07.05.2015
(51) Int. Cl.: H05K 1/02

(54) **CIRCUIT BOARD CROSS-BAND VENEER WITH FUNCTION OF ABSORBING INSTANTANEOUS HIGH-VOLTAGE ELECTRIC PULSE ENERGY AND MANUFACTURING METHOD THEREFOR**

(30) Priority: 09.05.2014 CN 201410195406; 09.05.2014 CN 201420241123 U
(71) Applicant: Wuhan Chip Protection Technology Co., Ltd., Wuhan, Hubei 430043 (CN)
(72) Inventor: WANG, Jing, Wuhan Hubei 430043 (CN); QIAO, Zhi, Wuhan Hubei 430043 (CN)
(74) Representative: Zeuner Summerer Stütz
(86) International application number: PCT/CN2015/078454
(87) International publication number: WO 2015/169234

(57) **Abstract**

A circuit board cross-band veneer with a function of absorbing instantaneous high-voltage electric pulse energy and a manufacturing method therefor. The functional cross-band veneer comprises a basic cross-band veneer composed of an insulation layer (2) and metal substrates (1) above and below the insulation layer, wherein a voltage impedance-transforming functional material layer (4) is attached to the metal substrate at one side of the cross-band veneer, and metal square layers (3) which are used for absorbing instantaneous high-voltage electric pulse energy and are arranged at intervals fill the voltage impedance-transforming functional material layer. The metal square layers comprise metal squares of which the length and width are 0.8mm respectively, wherein a plurality of metal squares are separated with lateral intervals and vertical intervals, and are arranged into a metal square array in a mode of being insulated from each other, and the horizontal interval and the vertical interval are 0.08mm respectively. These metal squares form an electric energy absorption array, thereby being beneficial to constructing an instantaneous electric energy absorption network in an application. The cross-band veneer for absorbing instantaneous high-voltage electric pulse energy in the present invention is suitable for being arranged in all multilayer circuit boards, so that components on the circuit boards have a shielding effect on instantaneous high-voltage electric pulse energy.

## Description

### TECHNICAL FIELD

The present invention relates to a core board of a functional circuit board that can absorb instant high-voltage electric pulse energy and its manufacturing method. As a technology applicable to the field of electronic manufacturing, it can be used to produce a new material for functional core board that can be used in the protection of electronic circuits and PCB board manufacturing.

### BACKGROUND OF THE INVENTION

In order to prevent the impact of instantaneous high-voltage electrical pulse energy such as static electricity, surges, and induced energy from transient potential field, so as to avoid damage to sensitive electronic components caused by the same, circuits of electronic devices mostly contains some functional circuits that can absorb such energy. At present these energy absorption circuits all exist as discrete components set in the circuits, including TVS tubes, ceramic varistor, polymer electrostatic suppressors, capacitors etc., all of which will take up a lot of PCB area, therefore it is required to make trade-offs between the reduction of equipment volume and improvement of equipment circuit protection, which is why there is no comprehensive protection against the impact of instant high voltage electrical impulse in the electronic circuits of today's electronic equipment, the reason for which also include that it is not possible to provide full protection for all pins of all sensitive devices in the circuit due to manufacturing cost considerations.

China Patent ZL201220475284.6 relates to a printed circuit board with full range of anti-static functions. The use of surface mounted polymer composite nano - voltage varistor soft film completely solves the issue regarding the protection against impact of instantaneous high voltage electrical pulse energy in the electronic circuits of single-layer circuit boards or double-panels and low-density small-scale wiring equipment. However, such protection is clearly inadequate for electronic circuits of large-scale high-density wiring devices and multi-layer circuit boards.

At present another program has been proposed by foreigners: first have the instantaneous pulse energy absorbing materials embedded in the circuit board interlayer, then use laser drilling to have the material surface connected with the protected element. Although it may well be a better solution, there are still insurmountable defects:
1. Embedding the material into the board increases the risk of board layering.
2. As the material thickness is limited to 100 µm (otherwise there will be loss of function), even with the most precise drilling rig, it is still very difficult to ensure that each drilling hole (between several µm) is exactly the same. As such and the fact that there are a few dozens or even hundreds of protection points in each board, even the wrong thickness of connection between materials in only one point (one hole) could cause the entire circuit board to be scrapped.
3. In this scheme, the diameter of the hole determines the contact area with the material. To obtain a larger electric energy discharge current, it is necessary to ensure that each hole area is large enough, in which case a larger area of PCB board will be occupied thereby. Multilayer circuit boards generally use u-hole (diameter less than 10 µm) for collusion connection, the protection points of which can only discharge energy, but not carry such energy, and then any slight overload of energy in only one point will break down the discharge point.
4. Difficult high-precision machining will inevitably bring unacceptable manufacturing costs, which is not conducive to the promotion and application of all electronic equipment.

Current PCB production processes all utilize double-sided metal plates as the core plates, and most of them are used with one side for grounding, the other as power supply pole.

### SUMMARY OF THE INVENTION

The object of the present invention is to utilize the earth electrode of the existing core plate. By setting functional material on the pole surface and arranging electric pulse absorbing block on such functional material, the invention provides a core board of a functional circuit board capable of absorbing instant high-voltage electric pulse energy and a manufacturing method of the same. The core board can absorb instant high-voltage electrical pulse energy.

The technical proposal of the invention: providing a core board of a functional circuit board that can absorb instant high-voltage electric pulse energy, which comprises a basic core board comprising an insulating layer and the metal substrates arranged up and down the same, with a layer of voltage-variable resistance functional material attached on one surface of such metal substrate and a layer of spaced small metal blocks arranged to fill the layer of voltage varistor functional materials, which are used to absorb the instantaneous high-voltage electrical pulse energy.

The layer of voltage varistor functional materials comprises polymer composite nano - voltage varistor soft film.

The layer of voltage varistor functional materials is obtained through mixing of polymers and conductive particles.

The small metal block layer comprises small metal blocks, each with a length and width of 0.8 mm and all of which form a metal block array through transverse and vertical spacing of both 0.08 mm as well as mutual insulation.

A method of manufacturing the core board of a functional circuit board, which comprises the following steps:
1) degreasing and conducting molecular activation treatment on the basic core metal surface and a metal foil having a thickness of 10 µm through common physical and chemical methods;
2) putting the polymer composite nano-voltage variable resistance soft film between the metal substrate of the decontaminated basic core sheet and a metal foil having a thickness of 10 m, then placing all of the three into a pressure hot-cover machine for hot pressing, to obtain a functional core board after natural cooling of the hot pressed product; and
3) processing the layer of metal foil attached to the top of the functional material layer of the functional core substrate by the ordinary etching method with the equal spacing of 0.08 mm and the length and width of 0.8 mm, so as to form a 0.8 mm × 0.8 mm equidistant array of small metal blocks on the metal foil surface, by which a core board capable of absorbing high-voltage electrical pulse energy can be obtained.

In step 2), the hot-pressing temperature of the hot-pressing machine is set to 120 °C, the pressure of the same is set to 2kg / cm2. The item is hot pressed for one minute and then removed from the machine for natural cooling.

The polymer composite nano-voltage varistor soft film is produced with polymer matrix materials and nano-conductive filler at the weight ratio of 100: 5.5 between the two, the thickness of which is 120 µm.

Another method of manufacturing the core board of a functional circuit board, which comprises the following steps:
1) degreasing and conducting molecular activation treatment on the basic core metal surface and a metal foil having a thickness of 10 µm through common physical and chemical methods;
2) adding polymer materials such as polymer epoxy resin or polyamide resin, polyurethane, polyether and other liquid high polymers, 100 parts by weight, and nano-conductive fillers, 5.5 parts by weight, in to the high-speed mixer, setting the mixer to 3000 rpm and running it for 10 minutes to obtain the sizing agent of composite nanometer voltage varistor materials; with respect to use of polymer materials, epoxy resins are preferred.
3) using the sizing agent of composite nanometer voltage varistor materials obtained through step 2) to conduct screen printing on the metal surface at one side of the treated basic core, so as to form a substrate grid with 2 cm x 2 cm square lattices, the height of which shall be between 0.1 mm and 0.12 mm;
4) placing the basic core sheet obtained in step 3) in a high temperature curing tank and treat the same at a temperature of 120 °C for 60 min, then applying the sheet to a coater and setting the coating thickness of the same to 0.1 mm to 0.12 mm, then applying the sizing agent of composite nanometer voltage varistor materials obtained through step 2) to the printed boxes;
5) pasting the 10 µm metal foil flat on the surface of the polymer composite nano-voltage varistor layer; after flattening of the foil and the polymer layer, placing the same in to a high temperature curing box for curing at 150 °C for 90 min, by which a functional core board can be obtained;
6) processing the layer of metal foil attached on the layer of polymer composite nanometer varistor materials within the functional core substrate by the ordinary etching method with the equal spacing of 0.08 mm and the length and width of 0.8 mm, so as to form a 0.8 mm × 0.8 mm equidistant array of small metal blocks on the metal foil surface, by which a core board capable of absorbing high-voltage electrical pulse energy can be obtained.

The mentioned metal foil is preferably a copper foil.

Advantages and significances of the invention are summarized as follows.

The invention adopts Chinese patent ZL201210314982.2 polymer composite nanometer voltage variable resistance soft film as the feature film, takes real mature processes, such as the thermoplastic, laminating, and as the process realization means, to provide reliable guarantee for the realization of the technology. Its advantages include:
1. Since conductive particles of the high polymer composite nanometer voltage variable resistance soft film contain polyurethane and epoxy resin with reaction gens, it is of good performance in affinity with metal film material, so that, the core board formed by adhesion of this kind of film and metal film has excellent peel strength (> 1.1 N/mm). Lamination is impossible for adhesion between this film and the prepreg used in PCB manufacturing.
2. Since the metal surface of this kind of core board is divided into several 0.8 mm x 0.8 mm squares, when using it to manufacture multi-layer PCB, it needs only to make the copper wire that needs to be protected in the circuit board surface or the interlayer connect to any point of the metal square surface of the core board via the prepreg blind hole. During the process of PCB copper plating process, at least one and maximum four metal squares of the core board shall be of electrical connection with the blind holes of the prepreg. In this way, it guarantees that all points needing protection on the circuit board would be reliably protected. Besides, it is easy to implement, even for common circuit board production process.
3. To the protection of large current discharge points, it only needs to set multiple blind holes on the copper wire with interval of 0.8 mm to make the protection connect to multiple metal squares on the functional core board, thus to gain a larger discharge power. It is very simple and flexible for using.
4. Very low manufacture cost, good for being promoted in application of all kinds of electronic devices.
5. It realizes overall protective functions for electronic circuit and provides wide design space for miniaturizing of electronic devices and enhancement of equipment function and reliability.

### BRIEF DESCRIPTION OF THE DRAWINGS

Figure 1 is a schematic diagram of a core board of a core board of the circuit core board with function of absorbing instantaneous high voltage pulse energy.
Figure 2 is a schematic diagram of small metal square.
Figure 3 is a side-view of a core board of a core board of the circuit core board with function of absorbing instantaneous high voltage pulse energy.

### DETAILED DESCRIPTION OF THE EMBODIMENTS

The invention is based on China's technical invention patent ZL201210314982.2, in order to thoroughly solve the problem of electronic circuit instantaneous high voltage electrical pulse energy impact of electronic equipment.

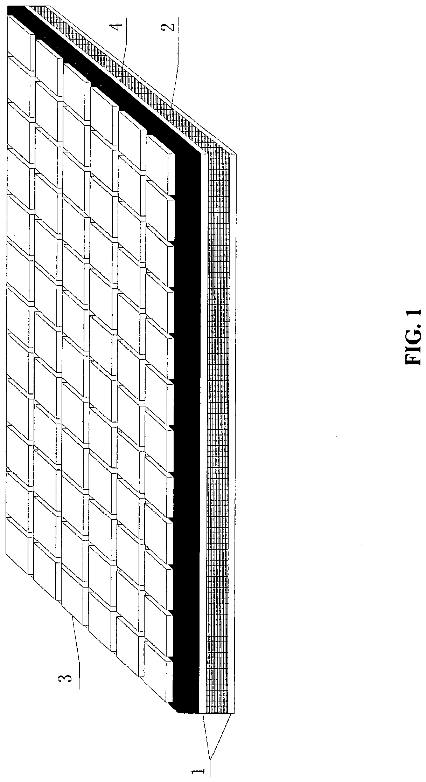

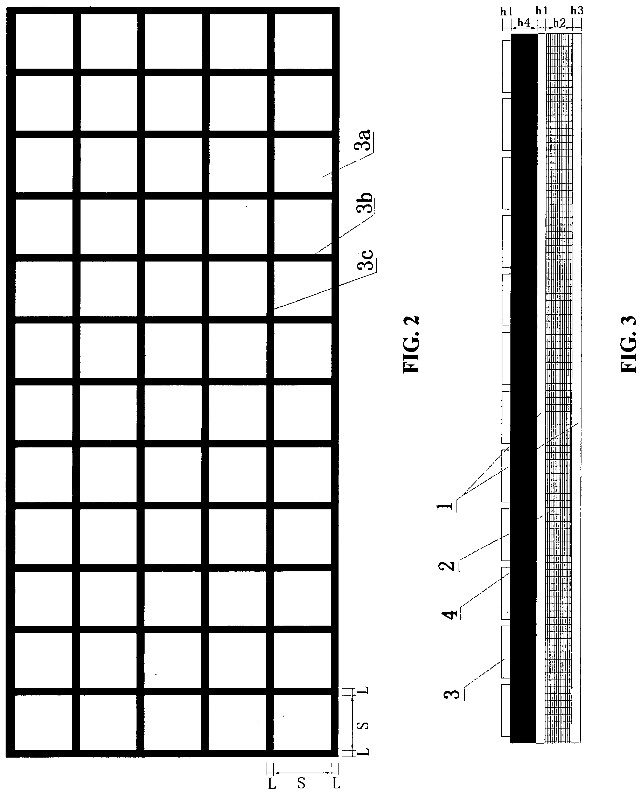

Figure 1 and 3 are structural schematic diagrams of the core board of the circuit core board with function of absorbing instantaneous high voltage pulse energy.

The invention of the core board of the circuit core board with the function of absorbing instantaneous high voltage electrical pulse energy includes the insulating layer 2 and the basic core board comprising metal substrate 1 above and below insulating layer 2. On the metal substrate 1 of one side of the basic core board, there attached a layer of a voltage variable resistance material layer 4, on which, small metal squares used for absorbing instantaneous high voltage electrical pulse energy are fully deployed.

Usually, the thickness h2 of the insulating layer 2 is 30 µm -300 µm. The thickness h1 of the metal substrate 1 above and below insulating layer = 7 µm - 12 µm. Thickness h4 of voltage variable resistance functional material layer 4 =100 µm - -120 µm. Thickness h3 of small metal square 3 =10 µm.

The mentioned voltage variable resistance functional material is Layer 4, which is the polymer nanometer voltage variable resistance soft film.

The mentioned voltage variable resistance functional material layer 4 is the material acquired by miscible of polymer and conducting particles.

Figure 2 is the schematic diagram of small metal square layer: the mentioned small metal square layer 3 includes small metal square 3a with length and width of S respectively; multiple small metal squares are separated by horizontal partition 3b and vertical partition 3c; they are insulating to each other and form the small metal square array. Width L of horizontal partition 3b and vertical partition 3c = 0.08 mm. When such pulse energy absorption array is set into the circuit board line, it would form the pulse energy discharge network, thus to create the environment having screen effect to high voltage pulse.

The steps of the first method for manufacturing the core board of the circuit board with function of absorbing instantaneous high voltage pulse energy are as follows:
1) Perform de-greasing and molecular activation by common physical and chemical methods for the metal surface of the basic core board and the surface of the metal foil with thickness of 10 µm;
2) Put the polymer composite nanometer voltage variable resistance soft film in-between the metal substrate 1 and the metal foil with thickness of 10 µm of the basic core board after being performed with cleaning process; and then put it into the pressure thermal coating machine and take it out for natural cooling after thermal pressing, to acquire basic plate of functional core board.
3) Process the metal foil on the functional material surface of the above mentioned functional core board substrate according to 0.08 mm interval and 0.8 mm length and width by common etching method, thus to make the metal foil of the functional material layer form 0.8 mm×0.8 mm equal space arranged small metal square array to acquire core board with function of instantaneous high voltage electric pulse energy absorbing.

Step 2) Adjust the temperature of the thermal pressing of the pressure thermal coating machine to 120 °C, adjust its pressure to 2 kg/ cm²; keep thermal pressing for one minute, then take it out for natural cooling to acquire functional core board substrate.

The adopted polymer composite nanometer voltage variable resistance soft film is fabricated according to the 100:5.5 proportions of base material and nano conductive stuffing. Its thickness is 120 µm.

The steps of the second kind of method for manufacturing the mentioned core board of the core board of a functional circuit board are as follows:
1) Perform de-greasing and molecular activation by common physical and chemical methods for the surface of the basic core board and the surface of the metal foil with thickness of 10 µm;
2) Put the liquid polymers, such as the polymer material epoxy resin/ polyamide resin, polyurethane, polyether, and the nano conductive stuffing according to the weight proportion of 100:5.5 into the high-speed mixer, adjust the rotational speed to 3000 RPM, start the mixer and keep stirring for 10 min to acquire polymer composite nanometer voltage variable resistance material pulp;
3) Take the polymer composite nanometer voltage variable resistance material pulp acquired in Step 2) to print 2cmx2cm grid on the surface of the metal substrate 1 on one side of the processed basic core board by screen printing way to form a substrate grid, for which, the height shall be controlled in the range of 0.1 mm-0.12 mm;
4) Put the basic core board with substrate grid acquired in Step 3) on the high temperature curing box, adjust temperature to 120°C to cure for 60 min; then take out and tile to the coating machine, adjust the coating thickness to 0.1 mm - 0.12 mm, and coat the polymer composite nanometer voltage variable resistance material pulp acquired in Step 2) into the printed grid;
5) Tile and adhere the 10 µm metal foil onto the surface of the coated polymer composite nanometer voltage variable resistance material layer, paste and press it till flat; then put it into the high temperature curing box, adjust temperature to 150 °C to cure for 90 min to acquire the substrate of the functional core board.
6) Process the metal foil on the functional material surface of the above mentioned functional core board substrate according to 0.08 mm interval and 0.8 mm length and width by common etching method, thus to make the metal foil of the functional material layer form 0.8 mm×0.8 mm equal space arranged small metal square array to acquire core board with function of instantaneous high voltage electric pulse energy absorbing

The mentioned metal foil is a copper foil.

The core of this invention is to combine the polymer nanometer composite voltage variable resistance material layer and the small metal square array to constitute a high voltage electrical pulse energy absorption array. The instantaneous electric energy absorption of network can be created under the cooperation of the resistor-capacitor element of the circuit by adding the array structure in the circuit board to make lead wire (copper wire) of the element of the circuit board that needs anti instantaneous electric pulse protection connect to any metal square of the array, or connecting all copper wires on the circuit board to the metal squares for one time (no need to repeatedly connect),energy the circuit boards need to resist instantaneous high voltage electrical protection components fuses (with copper wire) connected to the array of a small metal box, or will all the attached on the circuit board copper wire connected to the array with metal small squares in the time (no need to repeat the connection). When any point of the circuit is impacted by the high voltage electric pulse, the voltage variable resistance functional material layer on the surface of the metal square corresponding to this point would immediately change from high impedance state into conductive state (usually 1ns) to discharge such high voltage electric pulse to ground. When this energy is released, the function materials would instantly restore to high impedance state to make the sensitive components on circuit boards to be able to screen effect of instantaneous voltage electrical energy. Therefore, all manufacture plans of circuit boards adopting instantaneous high voltage electric pulse energy discharging method by using small metal squares setting (combination) on polymer composite nanometer voltage variable resistance layer shall belong to the protection scope of this invention.

## Claims

1. A core board of a functional circuit board that can absorb instant high-voltage electric pulse energy, comprising: a basic core board comprising an insulating layer (1) and metal substrates (2) arranged up and down the insulating layer (1), **characterized in that** a layer of voltage-variable resistance functional material (4) is attached on one surface of a metal substrate (2) at one side of the basic core board, and a layer of spaced small metal blocks (3) is arranged to fill the layer of voltage varistor functional materials (4), to absorb the instantaneous high-voltage electrical pulse energy.

2. The core board of claim 1, **characterized in that** the layer of voltage varistor functional materials (4) comprises polymer composite nano - voltage varistor soft film.

3. The core board of claim 1, **characterized in that** the layer of voltage varistor functional materials (4) is obtained through mixing of polymers and conductive particles.

4. The core board of claim 1, 2 or 3, **characterized in that** the small metal block layer (3) comprises small metal blocks (3a), each with a length and width of 0.8 mm and all of which form a metal block array through transverse spacing (3b) and vertical spacing (3c) of both at 0.08 mm as well as mutual insulation.

5. A method of manufacturing the core board of the functional circuit board of any one of claims 1-4, which comprises the following steps:
1) degreasing and conducting molecular activation treatment on the basic core metal surface and a metal foil having a thickness of 10 µm through common physical and chemical methods;
2) putting the polymer composite nano-voltage variable resistance soft film between the metal substrate of the decontaminated basic core sheet and a metal foil having a thickness of 10 m, then placing all of the three into a pressure hot-cover machine for hot pressing, to obtain a functional core board after natural cooling of the hot pressed product; and
3) processing the layer of metal foil attached to the top of the functional material layer of the functional core substrate by the ordinary etching method with the equal spacing of 0.08 mm and the length and width of 0.8 mm, so as to form a 0.8 mm × 0.8 mm equidistant array of small metal blocks on the metal foil surface, by which a core board capable of absorbing high-voltage electrical pulse energy can be obtained

6. The method of claim 5, **characterized in that** in step 2), the hot-pressing temperature of the hot-pressing machine is set to 120 °C, the pressure of the same is set to 2kg/cm²; the item is hot pressed for one minute and then removed from the machine for natural cooling.

7. The method of claim 5 or 6, **characterized in that** the polymer composite nano-voltage varistor soft film is produced with polymer matrix materials and nano-conductive filler at the weight ratio of 100: 5.5 between the two, the thickness of which is 120 µm.

8. A method of manufacturing the core board of a functional circuit board of any one of claims 1-4, which comprises the following steps:
1) degreasing and conducting molecular activation treatment on the basic core metal surface and a metal foil having a thickness of 10 µm through common physical and chemical methods;
2) adding polymer materials such as polymer epoxy resin or polyamide resin, polyurethane, polyether and other liquid high polymers, 100 parts by weight, and nano-conductive fillers, 5.5 parts by weight, in to the high-speed mixer, setting the mixer to 3000 rpm and running it for 10 minutes to obtain the sizing agent of composite nanometer voltage varistor materials; with respect to use of polymer materials;
3) using the sizing agent of composite nanometer voltage varistor materials obtained through step 2) to conduct screen printing on the metal surface at one side of the treated basic core, so as to form a substrate grid with 2 cm x 2 cm square lattices, the height of which shall be between 0.1 mm and 0.12 mm;
4) placing the basic core sheet obtained in step 3) in a high temperature curing tank and treat the same at a temperature of 120 °C for 60 min, then applying the sheet to a coater and setting the coating thickness of the same to 0.1 mm to 0.12 mm, then applying the sizing agent of composite nanometer voltage varistor materials obtained through step 2) to the printed boxes;
5) pasting the 10 µm metal foil flat on the surface of the polymer composite nano-voltage varistor layer; after flattening of the foil and the polymer layer, placing the same in to a high temperature curing box for curing at 150 °C for 90 min, by which a functional core board can be obtained; and
6) processing the layer of metal foil attached on the layer of polymer composite nanometer varistor materials within the functional core substrate by the ordinary etching method with the equal spacing of 0.08 mm and the length and width of 0.8 mm, so as to form a 0.8 mm × 0.8 mm equidistant array of small metal blocks on the metal foil surface, by which a core board capable of absorbing high-voltage electrical pulse energy can be obtained.

9. The method of claim 8, **characterized in that** the polymer materials are epoxy resins.

10. The method of claim 5 or 8, **characterized in that** the metal foil is a copper foil.
